# EUROPEAN PATENT SPECIFICATION

(11) **EP 1 042 105 B1**
(45) Date of publication and mention of the grant of the patent: **12.11.2003**
(21) Application number: 98966113.7
(22) Date of filing: 29.12.1998
(51) Int. Cl.: B24B 37/04, B24D 13/14

(54) **METHOD AND APPARATUS FOR MECHANICAL AND CHEMICAL-MECHANICAL PLANARIZATION OF MICROELECTRONIC SUBSTRATES**
APPARAT UND METHODE FÜR DIE MECHANISCHE UND CHEMISCH-MECHANISCHE PLANARISIERUNG VON MIKROELEKTRONIKSUBSTRATEN
PROCEDE ET APPAREIL POUR REALISER LA PLANEITE DE SUBSTRATS MICROELECTRONIQUES PAR VOIE MECANIQUE ET CHIMICO-MECANIQUE

(30) Priority: 30.12.1997 US 1333
(43) Date of publication of application: 11.10.2000
(73) Proprietor: MICRON TECHNOLOGY, INC., Boise, ID 83707-0006 (US)
(72) Inventor: MOORE, Scott, E., Meridian, ID 83642 (US)
(74) Representative: Klunker . Schmitt-Nilson . Hirsch
(86) International application number: PCT/US98/27773
(87) International publication number: WO 99/033615

(56) References cited:
- EP-A- 0 685 299
- WO-A-94/04599
- WO-A-96/15887
- WO-A-97/47433
- US-A- 5 624 303

## Description

### TECHNICAL FIELD

The present invention relates to mechanical and chemical-mechanical planarization of microelectronic substrates. More particularly, the present invention relates to a planarization polishing medium for enhancing the performance and/or reducing the costs of planarizing substrates, and to methods and machines using the polishing pad.

### BACKGROUND OF THE INVENTION

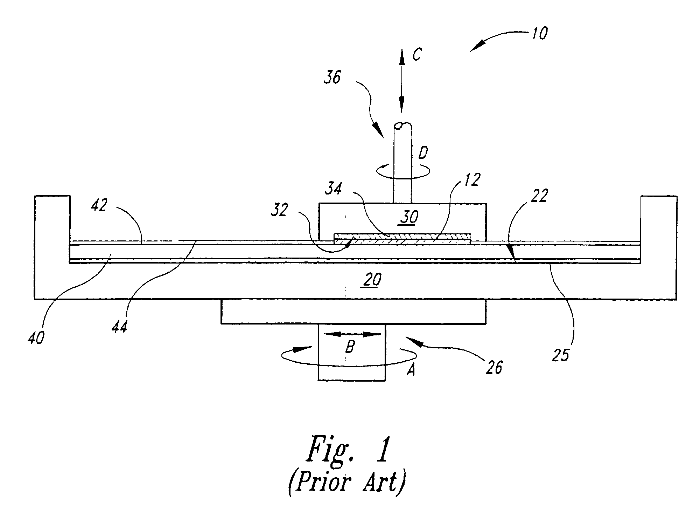

Mechanical and Chemical-Mechanical planarization processes remove material from the surface of semiconductor wafers, field emission displays and many other microelectronic substrates to form a flat surface at a desired elevation in the substrates. Figure 1 schematically illustrates a planarizing machine 10 with a platen 20, a carrier assembly 30, a polishing pad 40, and a planarizing solution 44 on the polishing pad 40. The planarizing machine 10 may also have a compressible under-pad 25 attached to an upper surface 22 of the platen 20 for supporting the polishing pad 40. In many planarizing machines, a drive assembly 26 rotates (arrow A) and/or reciprocates (arrow B) the platen 20 to move the polishing pad 40 during planarization.

The carrier assembly 30 controls and protects a substrate 12 during planarization. The carrier assembly 30 generally has a lower surface 32 with a pad 34 that holds the substrate 12 via suction, and an actuator assembly 36 is typically attached to the carrier assembly 30 to rotate and/or translate the substrate 12 (arrows C and D, respectively). However, some carrier assemblies 30 are weighted, free-floating disks (not shown) that slide over the polishing pad 40.

The polishing pad 40 and the planarizing solution 44 may separately, or in combination, define a polishing environment that mechanically and/or chemically removes material from the surface of the substrate 12. The polishing pad 40 may be a conventional polishing pad made from a relatively compressible, porous continuous phase matrix material (*e.g*., polyurethane), or it may be an abrasive polishing pad with abrasive particles fixedly bonded to a suspension medium. The planarizing solution 44 may be a chemical-mechanical planarization slurry with abrasive particles and chemicals for use with a conventional non-abrasive polishing pad, or the planarizing solution 44 may be a liquid without abrasive particles for use with an abrasive polishing pad. To planarize the substrate 12 with the planarizing machine 10, the carrier assembly 30 presses the substrate 12 against a planarizing surface 42 of the polishing pad 40 in the presence of the planarizing solution 44. The platen 20 and/or the carrier assembly 30 then move relative to one another to translate the substrate 12 across the planarizing surface 42. As a result, the abrasive particles and/or the chemicals in the polishing environment remove material from the surface of the substrate 12.

Planarizing processes must consistently and accurately produce a uniformly planar surface on the substrate to enable precise fabrication of circuits and photo-patterns on the substrate. As the density of integrated circuits increases, the uniformity and planarity of the substrate surface is becoming increasingly important because it is difficult to form sub-micron features or photo-patterns to within a tolerance of approximately 0.1 µm when the substrate surface is not uniformly planar. Thus, planarizing processes must create a highly uniform, planar surface on the substrate.

In conventional planarizing processes, the substrate surface may not be uniformly planar because the rate at which material is removed from the substrate surface (the "polishing rate") typically varies from one region on the substrate to another. The polishing rate depends, in part, upon the distribution of abrasive particles and chemicals between the substrate surface and the polishing pad. One particular problem with conventional planarizing devices and methods is that the perimeter of the substrate wipes a significant amount of the planarizing solution off of the polishing pad. As such, the planarizing solution builds up in a high zone along a leading edge of the substrate, which reduces the volume of planarizing solution contacting the center of the substrate. Conventional planarizing devices and methods, therefore, typically produce a non-uniform, center-to-edge planarizing profile across the substrate surface.

To reduce such a center-to-edge planarizing profile, several conventional non-abrasive polishing pads have holes or grooves on their upper surfaces to transport a portion of the planarizing solution below the substrate surface during planarization. A Rodel IC-1000 polishing pad, for example, is a relatively soft, porous polyurethane pad with a number of large slurry wells approximately 0.05-0.10 inches in diameter that are spaced apart from one another across the planarization surface by approximately 0.125-0.25 inches. The large wells are expected to hold small volumes of slurry below the planarizing surface so that the substrate may draw the slurry out of the wells as the substrate translates over the pad. However, such pads still produce a significant center-to-edge planarizing profile indicating that the perimeter of the substrate presses some of the slurry out of the wells ahead of the center of the substrate. U.S. Patent No. 5,216,843 describes another polishing pad with a plurality of macro-grooves formed in concentric circles and a plurality of microgrooves radially crossing the macro-grooves. Although such grooves may improve the planarity of the substrate surface, substrates planarized with such pads still exhibit non-uniformities across the substrate surface indicating an inadequate distribution of planarizing solution and abrasive particles across the substrate.

Other types of polishing pads also do not adequately resolve the center-to-edge planarizing profile. For example, conventional porous polishing pads with small micro-pores at the planarizing surface are generally subject to producing a center-to-edge planarizing profile indicating that the perimeter of the substrate presses the planarizing solution out of the pores before the center of the substrate passes over the pores. Additionally, even fixed-abrasive polishing pads that have a uniform distribution of abrasive particles may produce a center-to-edge planarizing profile because the perimeter of the substrate also tends to sweep the planarizing solution off of abrasive polishing pads. Therefore, conventional polishing pads typically produce an undesired center-to-edge planarizing profile on the substrate surface.

To improve the distribution of slurry under the substrate, U.S. Patent No. 5,489,233 discloses a polishing pad composed of a solid, uniform polymer sheet having no intrinsic ability to absorb or transport slurry particles. One type of polymer sheet disclosed in U.S. Patent No. 5,489,233 is Mylar® manufactured by E.I. du Pont de Nemours of Wilmington, Delaware. The Polymer sheet has a surface pattern or texture that has both large and small flow channels to permit the transport of slurry across the surface of the polishing pad. The channels are mechanically produced on the pad. In a preferred embodiment, the pad has a macro-texture produced prior to planarization and a micro-texture produced by abrading the pad with a plurality of small abrasive points at regular selected intervals during planarization. Although the pad disclosed in U.S. Patent No. 5,489,233 improves the uniformity of the substrate surface in some circumstances, it may not provide consistent planarization characteristics because scratching the surface with small abrasive points may not duplicate the micro-texture from one pad to the next. Thus, the polishing pad described in U.S. Patent No. 5,489,233 may not provide consistent results from one substrate to the next.

Another factor affecting the uniformity of the substrate surface is the condition of the polishing pad. The planarizing surface of the polishing pad typically deteriorates after polishing a number of substrates because waste matter from the substrate, planarizing solution and/or the polishing pad accumulates on the planarizing surface. The waste matter alters the local planarizing characteristics of the pad, and the waste matter typically does not accumulate uniformly across the planarizing surface. Thus, the waste matter accumulations cause the polishing rate to vary across the surface of the polishing pad.

Polishing pads are accordingly "conditioned" by removing the waste matter from the pad to restore the polishing pad to a suitable condition for planarizing substrates. However, even conditioning polishing pads may produce non-uniformities in the substrate surface because it is difficult to consistently condition a polishing pad so that it has the same planarizing characteristics from one conditioning cycle to the next. Conditioning the polishing pads, moreover, is time-consuming and requires costly equipment and labor. Therefore, in addition to the problems associated with providing an adequate distribution of planarizing solution between the substrate surface and the polishing pad, conditioning conventional polishing pads may also reduce the uniformity of the planarized substrate surface.

### SUMMARY OF THE INVENTION

The present invention is defined in claim 1. Claims 2 to 68 are concerned with embodiments of the invention.

### BRIEF DESCRIPTION OF THE DRAWINGS

Figure 1 is a schematic view of a planarizing machine in accordance with the prior art.
Figure 2 is a schematic view of a planarizing machine with a planarizing medium.
Figure 3 is a partial isometric view of a planarizing medium with a planarizing film and a plurality of micro-features in accordance with one embodiment of the invention.
Figure 4 is a partial schematic cross-sectional view of the planarizing medium shown in Figure 3 along section 4-4.
Figure 5 is a partial schematic cross-sectional view of the planarizing medium of Figure 4 shown planarizing a substrate using a planarizing solution with abrasive particles in accordance with an embodiment of the invention.
Figure 6 is a partial schematic isometric view of another planarizing medium in accordance with another embodiment of the invention.

### DETAILED DESCRIPTION OF THE INVENTION

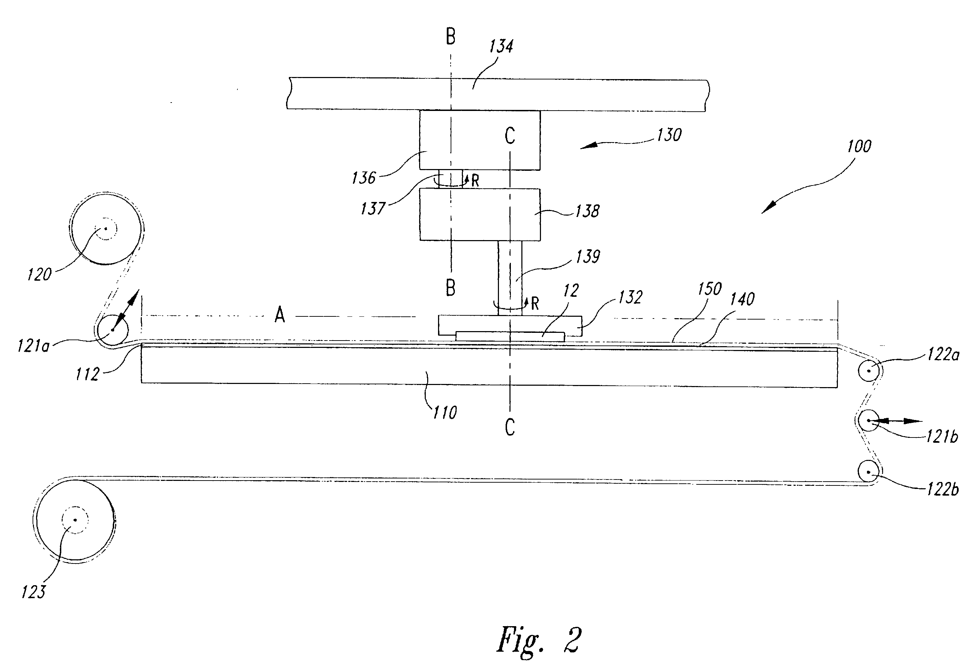

The present invention relates to a planarizing medium for planarization of substrates used in the manufacturing of microelectronic devices. Many specific details of certain embodiments of the invention are set forth in the following description and in Figures 2-6 to provide a thorough understanding of such embodiments. One skilled in the art, however, will understand that the present invention may have additional embodiments and may be practiced without several of the details described in the following description.

Figure 2 is a schematic view of an embodiment of a planarizing machine 100 and a planarizing medium 140 for planarizing a substrate 12. The features and advantages of the planarizing medium 140 are best understood in the context of the structure and operation of the planarizing machine 100. Thus, the general features of the planarizing machine 100 will be described initially.

The planarization machine 100 may have a support table 110 carrying a base 112 at a workstation or a planarization station where a section "A" of the planarizing medium 140 is positioned. The base 112 is generally a substantially incompressible support member attached to the table 110 to provide a flat, solid surface to which a particular section of the planarizing medium 140 may be secured during planarization. The planarizing machine 100 also has a plurality of rollers to guide, position and hold the planarizing medium 140 over the base 112. In one embodiment, the rollers include a supply roller 120, first and second idler rollers 121a and 121b, first and second guide rollers 122a and 122b, and a take-up roller 123. The supply roller 120 carries an unused part of the planarizing medium 140, and the take-up roller 123 carries a used part of the planarizing medium 140. The supply roller 120 and take-up roller 123 are driven rollers to sequentially advance unused portions of the planarizing medium 140 onto the base 112. As such, unused portions of the planarizing medium may be quickly substituted for worn used portions to provide a consistent surface for planarizing the substrate 12. Each portion of the planarizing medium 140 may correspond to an individual section "A" of the planarizing medium 140, but each portion may also be more or less than an individual section "A." The first idler roller 121a and the first guide roller 122a position the planarizing medium 140 slightly below the base 112 so that the supply and take-up rollers 120 and 123 stretch the planarizing medium 140 under tension to hold it stationary on the base 112 during planarization.

The planarization machine 100 also has a carrier assembly 130 to translate the substrate 12 across the planarizing medium 140. In one embodiment, the carrier assembly 130 has a substrate holder 132 to pick up, hold and release the substrate 12 at appropriate stages of the planarization process. The carrier assembly 130 may also have a support gantry 134 carrying an actuator 136 so that the actuator 136 can translate along the gantry 134. The actuator 136 preferably has a drive shaft 137 coupled to an arm assembly 138 that carries the substrate holder 132. In operation, the gantry 134 raises and lowers the substrate 12, and the actuator 136 orbits the substrate 12 about an axis B-B via the drive shaft 137. In another embodiment, the arm assembly 138 may also have an actuator (not shown) to drive a shaft 139 of the arm assembly 138 and thus rotate the substrate holder 132 about an axis C-C as the substrate holder 132 also orbits about the axis B-B. One suitable planarizing machine is manufactured by EDC Corporation. In light of the embodiment of the planarizing machine 100 described above, a specific embodiment of the planarizing medium 140 will now be described.

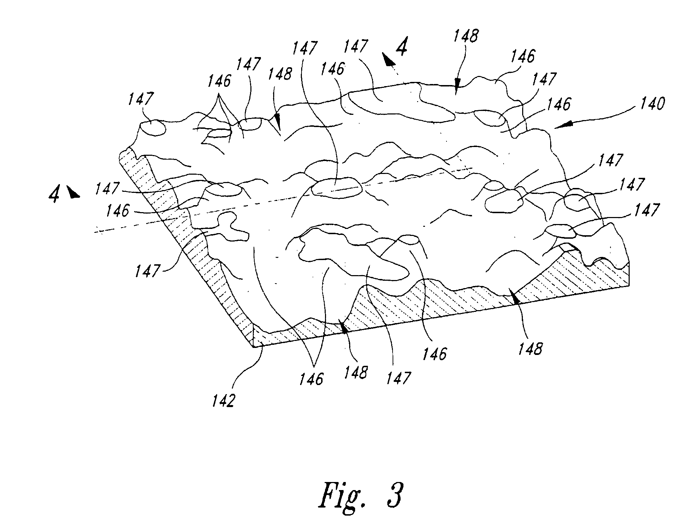

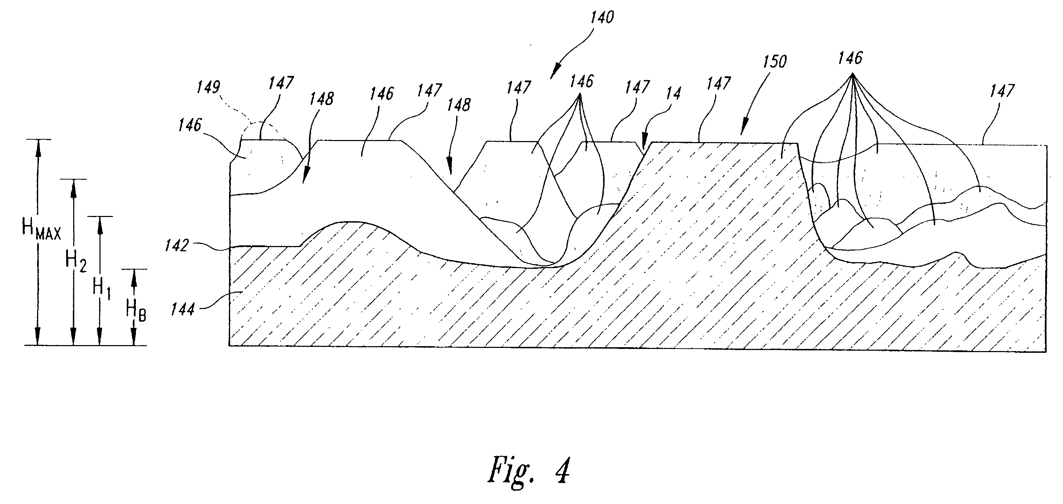

Figure 3 is a partial isometric view of an embodiment of the planarizing medium 140, and Figure 4 is a partial schematic cross-sectional view of the planarizing medium 140 shown in Figure 3 taken along section 4-4. The planarizing medium 140 has a planarizing film 142 and a plurality of micro-features 146 configured in a selected pattern on the film 142. The planarizing film 142 may be composed of a thin, inexpensive material that is impervious to the planarizing solution or generally impermeable to fluids. The planarizing film 142 is also preferably a flexible, yet substantially incompressible material that has a relatively high tensile strength. For example, the planarizing film may be a disposable material with a thickness between approximately 0.0005 inches and 0.050 inches. In some particular embodiments of the planarizing medium 140, the planarizing film 142 may be a mono-layer web or sheet composed of polymeric or other suitable materials. For example, two specific polymers suitable for the planarizing film 142 are polyester (*e.g*., Mylar manufactured by E.I. du Pont de Nemours Co.) and polycarbonate (*e.g*., Lexan manufactured by General Electric Co.). Other suitable polymers include polyurethane and nylon.

The micro-features 146 may be configured in a selected pattern on the film 142 to restrain fluid flow or otherwise entrap small micro-volumes of the planarizing solution (not shown) under a substrate surface (not shown) across the film 142. The selected pattern of micro-features 146 may be reproduced from a master pattern that consistently duplicates the selected pattern across all or a portion of the planarizing medium 140. In one embodiment, for example, the selected pattern is duplicated on portions of the planarizing medium 140 corresponding to the size of the section "A" at the planarization station of the planarizing machine 100 (Figure 2). Accordingly, the planarizing characteristics of the planarizing medium 140 are consistent from one section to the next to enhance the accuracy of the planarizing process. The selected pattern of micro-features 146 may be a substantially random distribution of features across the planarizing film 142, or the micro-features may be formed in a substantially symmetrical, uniform pattern. The micro-features 146 may also be formed integrally with the film 142, or the micro-features may be composed of a separate material attached to a flat sheet of film.

As shown in Figures 3 and 4, the micro-features 146 may be nodules with different shapes and heights that form depressions 148 in the film 142 between the nodules 146. As best shown in Figure 4, the planarizing film 142 has a contiguous portion 144 up to a height H_{B}, and the nodules 146 extend upwardly from the height H_{B} to a plurality of different heights. For example, a few of the nodules 146 may extend to a plurality of intermediate heights H₁ and H₂, while other nodules are flat-top nodules 147 terminating at a substantially constant height Hₘₐₓ defining a planarizing surface 150 (Figure 4 only) of the planarizing medium 140. The flat-top nodules 147 may define first raised features that act as support points on the planarizing surface 150 to engage or otherwise support the substrate 12, and the remaining nodules 146 with intermediate heights may define second raised features. Additionally, the depressions 148 may form at least one cavity below the flat-top nodules 147. In another embodiment, even the highest nodules may have rounded peaks 149 (shown in phantom in Figure 4) instead of the flat-top nodules 147. The nodules 146 preferably have heights of 0.5 µm to 100 µm with respect to the height H_{B}, and they are approximately 50 µm to 500 µm across at their base.

The selected pattern of micro-features 146 and depressions 148 illustrated in Figures 3 and 4 represents only one embodiment of a planarizing medium 140 suitable for planarizing microelectronic substrates. As such, virtually any pattern of micro-features that provides an adequate distribution of planarizing solution and abrasive particles underneath a substrate during planarizing may be used. Additionally, the nodules 146 may have other sizes and heights outside of the ranges set forth above.

The micro-features 146 may be formed on the planarizing film 142 by a number of methods. For example, when the planarizing film 142 is composed of a polymeric material, the selected pattern of micro-features 146 may be duplicated on the planarizing medium 140 by embossing the selected pattern of micro-features onto the planarizing film 142 with a die or stamp having the inverse of the selected pattern of micro-features. The die may be pressed against the planarizing film at a temperature sufficient to allow the film to permanently conform to the topography of the die. In the embodiment of the planarizing medium 140 illustrated in Figures 3 and 4, the micro-features 146 are formed by embossing a 0.010 to 0.020 inch thick film of Lexan with a die having a pattern of rounded nodules, and then planarizing a sacrifice wafer on the rounded nodules to form the flat-top nodules 147 at the maximum height Hₘₐₓ. In another embodiment, the selected pattern may be photo-patterned and then etched into the planarizing film. Thus, unlike micro-features that are scratched or abraded into a thin sheet, the selected pattern may be accurately duplicated across all or part of the planarizing medium to provide consistent planarization characteristics from one substrate to the next.

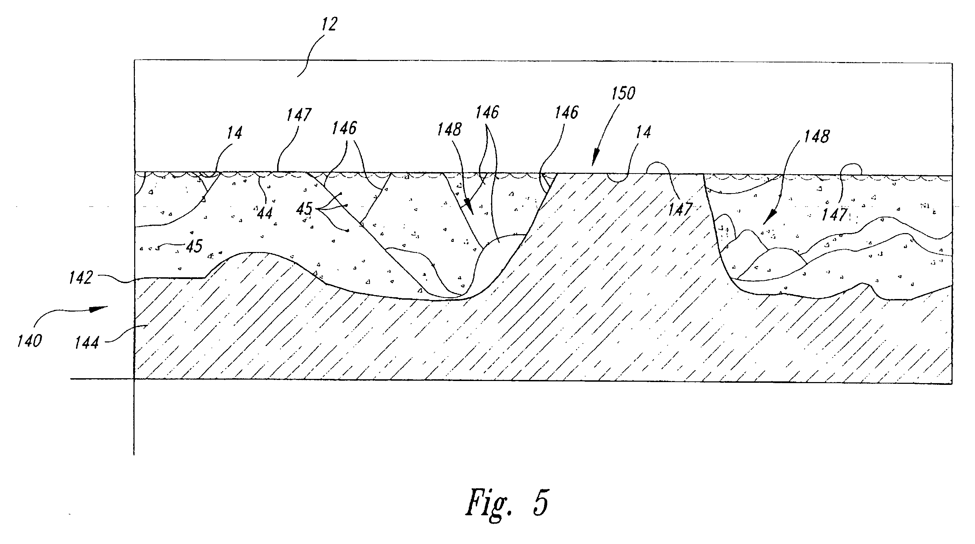

Figure 5 is a schematic cross-sectional view that illustrates the operation and some advantages of the planarizing medium 140. In operation, a supply line (not shown) deposits planarizing solution 44 onto the planarizing medium 140 as the carrier assembly 30 (Figure 1) translates the substrate 12 over the flat-top nodules 147. A small volume of the planarizing solution 44 accumulates in the depressions 148 between the nodules 146. Additionally, when the planarizing solution contains abrasive particles 45, a portion of the abrasive particles 45 may also accumulate in the depressions 148. The depressions 148 accordingly provide at least one large cavity under the flat-top nodules 147 to preferably hold a substantially uniform, contiguous distribution of planarizing solution 44 and abrasive particles 45 under a surface 14 of the wafer 12. The nodules 146 restrain the flow or otherwise entrap the planarizing solution 44 and the abrasive particles 45 to inhibit the perimeter of the substrate 12 from sweeping the solution 44 and the particles 45 off of the medium 140. Additionally, when nodules 146 are substantially incompressible, the flat-topped nodules 147 prevent the substrate 12 from penetrating into the depressions 148 and forcing the planarizing solution 44 and the abrasive particles 45 out of the depressions 148.

Compared to conventional polishing pads, the planarizing medium 140 is expected to produce highly uniform, planar surfaces on semiconductor wafers and other microelectronic substrates. The planarizing medium 140 is believed to improve the planarizing performance because the micro-features 146 restrain the fluid flow or otherwise entrap a substantially uniform, contiguous distribution of planarizing solution 44 and abrasive particles 45 in the depressions 148 underneath the surface 14 of the substrate 12. Additionally, the film 142 may be a highly planar, substantially incompressible sheet or web that does not conform to the topography of the substrate surface 14. The planarizing medium 140 accordingly imparts high mechanical energy to high points on the substrate surface 14, while inhibiting the substrate 12 from sweeping the planarizing solution 44 and abrasive particles 45 off of the planarizing medium 140.

In addition to the advantages described above, the planarizing medium 140 illustrated in Figures 3-5 may also provide a very consistent, inexpensive surface for planarizing substrates. Unlike conventional polishing pads composed of polyurethane or containing fixed abrasive particles, the planarizing medium 140 may be composed of an inexpensive, disposable film 142 that may be economically thrown away after the planarizing surface 150 is no longer in a state suitable for planarizing substrates. As a result, expensive conditioning equipment and skilled labor are not necessary to provide a clean planarizing surface. Additionally, because the selected pattern of micro-features may be duplicated across the planarizing medium 140, consistent planarizing characteristics may be maintained over a larger number of substrates. Therefore, the planarizing medium 140 may not only eliminate the need to constantly condition the planarizing surface, it may also enhance the consistency of the planarizing characteristics over a large number of substrates.

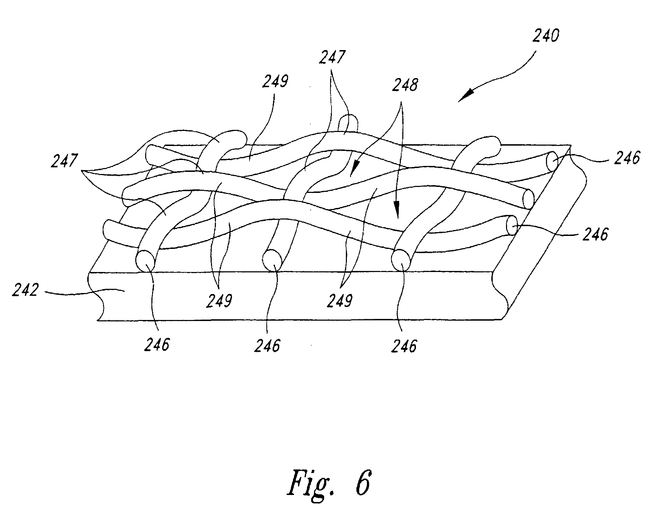

Figure 6 is a partial schematic isometric view illustrating another embodiment of a planarizing medium 240 in accordance with the invention with a planarizing film 242 and a plurality of micro-features 246 formed separately from the planarizing film 242. The planarizing film 242 may be similar to the film 142 discussed above with respect to Figures 3-5. The micro-features 246, however. may be a fine woven mesh of strands attached to the film 242. For example, the micro-features 246 may be a woven mesh of 2.0 µm to 5.0 µm diameter nylon strands spaced apart by openings 248 that define approximately 0.5% to 5% of the surface area of the mesh. The woven mesh accordingly has a plurality of first raised features defined by high points 247 along the strands, a plurality of second raised features 249 defined by the remainder of the strands above the film 242, and at least one cavity below the high points 247 of the strands defined by the openings 248. The micro-features 246 and openings 248 of the planarizing medium 240 may thus capture and contain a planarizing solution (not shown) beneath the high points 247 of the micro-features 246 to provide a substantially uniform distribution of planarizing solution and abrasive particles underneath the substrate (not shown) during planarization. The embodiment of the planarizing medium 240 illustrated in Figure 6, therefore, may achieve many of the same advantages described above with respect to the embodiment of the planarizing medium 140 illustrated in Figures 3-5.

From the foregoing it will be appreciated that, although specific embodiments of the invention have been described herein for purposes of illustration, various modifications may be made without deviating from the scope of the invention. For example, other patterns of micro-features may be used, and the woven mesh shown in Figure 6 may be composed of strands made from other materials. Additionally, planarizing media in accordance with the invention are not necessarily limited or required to achieve substantially the same results as the embodiments of planarizing media 140 and 240 described above. The invention, therefore, is not limited except as by the appended claims.

## Claims

1. A planarizing medium (140, 240) for planarizing microelectronic substrates, comprising:
a planarizing film (142, 242) impervious to a solution; and
a plurality of micro-features (146, 246) configured in a selected, duplicated pattern on the film, the selected pattern having a plurality of first raised features (147, 247) defining support points, at least one cavity below the support points, and a plurality of second raised features (249) between and below the support points.

2. The planarizing medium of claim 1 wherein the film is composed of a substantially incompressible polymer and the first and second raised features are formed from the film.

3. The planarizing medium of claim 2 wherein the polymer comprises polyester.

4. The planarizing medium of claim 2 wherein the copolymer comprises polycarbonate.

5. The planarizing medium of claim 2 wherein the polymer comprises polyurethane.

6. The planarizing medium of claim 2 wherein the polymer comprises nylon.

7. The planarizing medium of claim 2 wherein the first and second raised features comprise nodules having a plurality of shapes and heights, the nodules being patterned on the film to form a plurality of depressions between the nodules and so that at least a portion of the nodules define the support points.

8. The planarizing medium of claim 7 wherein the first raised features have flat tops terminating at a constant maximum height across the planarizing surface of the film.

9. The planarizing medium of claim 7 wherein the nodules are embossed on the film.

10. The planarizing medium of claim 9 wherein the selected pattern is substantially random configuration of nodules across an operating region of the planarizing surface.

11. The planarizing medium of claim 10 wherein the polymer comprises polyester.

12. The planarizing medium of claim 10 wherein the copolymer comprises polycarbonate.

13. The planarizing medium of claim 1 wherein:
the film comprises a polymer body with an upper surface; and
the micro-features comprise a fine mesh on the upper surface of the film having woven strands, the first raised features being high points along the strands and the second raised features being side portions of the strands.

14. The planarizing medium of claim 13 wherein:
the polymer comprises polyester; and
the fine mesh comprises small nylon fibers woven in a mesh with 0.5% to 5% openings.

15. The planarizing medium of claim 14 wherein the nylon fiber comprise 2.0 µm to 5.0 µm fibers.

16. The planarizing medium of claim 1 wherein the film comprises a flexible web wrapped around a supply roller and a take-up roller, and wherein the pattern of micro-features is duplicated across the web.

17. The planarizing medium of claim 16 wherein a first portion of the web is held at a work station of a planarization machine to planarize a first substrate, and the web is subsequently advanced to position a second portion of the web at the work station to planarize a second substrate.

18. The planarizing medium of claim 1 wherein the planarizing film comprises a separate sheet removably attached to a work station of a planarization machine.

19. A planarizing machine for planarizing a microelectronic substrate, comprising:
the planarizing medium as defined in any of claims 1 to 18
a support base ; and
said separate non-abrasive, incompressible planarizing film positioned on the base, said first raised features having first peaks at a first height defining said support points to contact the substrate and a said second raised features having second peaks at heights less than the first height.

20. The planarizing machine of claim 19 wherein the film comprises a flexible web wrapped around a supply roller and a take-up roller, and wherein a portion of the web extending between the supply and take-up rollers is held over the base.

21. The planarizing machine of claim 20 wherein the web is held stationary over the base during planarization by tensioning the web between the supply and take-up rollers.

22. The planarizing machine of claim 19 wherein the film comprises a separate sheet removably attached to the base.

23. The planarizing machine of claim 22 wherein the sheet is clamped to the base under tension.

24. The planarizing machine of claim 19 wherein the base comprises an incompressible plate.

25. The planarizing machine of claim 15 wherein the film is composed of a substantially incompressible polymer and the micro-features are formed from the film.

26. The planarizing machine of claim 15 wherein the micro-features comprise nodules having a plurality of shapes and heights, the nodules being patterned on the film to form a plurality of depressions between the nodules that entrap the solution.

27. The planarizing machine of claim 26 wherein a portion of the nodules have flat tops terminating at a constant maximum height across the planarizing surface of the film.

28. The planarizing machine of claim 26 wherein the nodules are embossed on the film.

29. The planarizing machine of claim 26 wherein the depressions are etched into the film.

30. The planarizing machine of claim 26 wherein the selected pattern is substantially random configuration of nodules across an operating region of the planarizing surface.

31. The planarizing machine of claim 19 wherein:
the film comprises a polymer; and
the micro-features comprises a fine mesh on the film.

32. The planarizing medium of claim 1, wherein said planarization film is a disposable mono-layer planarizing film having a thickness of between approximately 0.0005 and 0.050 inches and a planarizing surface with a plurality of micro-features, the plurality of micro-features defining fine depressions across the planarizing surface having depths between 0.5 and 100 µm.

33. The planarizing medium of claim 32 wherein the film comprises a flexible web adapted to be wrapped around a supply roller and a take-up roller so that the web may be indexed across a planarizing station of a planarizing machine.

34. The planarizing medium of claim 33 wherein the web comprises a polymer material.

35. The planarizing medium of claim 34 wherein the polymer material comprises polyester.

36. The planarizing medium of claim 34 wherein the polymer material comprises polycarbonate.

37. The planarizing medium of claim 34 wherein the polymer web has a thickness approximately between 0.0005 and 0.003 inches.

38. The planarizing medium of claim 37 wherein the depths of the depressions formed by the micro-features is approximately between 1 and 10 µm.

39. The planarizing medium of claim 38 wherein the web has a plurality of sections and each section has an identical pattern of micro-features.

40. The planarizing medium of claim 32 wherein the film comprises a sheet adapted to be attached to a planarizing station of a planarizing machine.

41. The planarizing medium of claim 40 wherein the sheet comprises a polymer material.

42. The planarizing medium of claim 41 wherein the polymer material comprises polyester.

43. The planarizing medium of claim 41 wherein the polymer material comprises polycarbonate.

44. The planarizing medium of claim 41 wherein the copolymer sheet has a thickness approximately between 0.0005 and 0.003 inches.

45. The planarizing medium of claim 44 wherein the depths of the depressions formed by the micro-features is approximately between 1 and 10 µm.

46. The planarizing medium of claim 45 wherein the sheet has a plurality of sections and each section has an identical pattern of micro-features.

47. The planarizing medium of claim 32 wherein the depths of the depressions formed by the micro-features is approximately between 0.5 µm and 10 µm.

48. A method of planarizing a microelectronic substrate making use of the planarizing medium defined in any of claim 1 to 18 and 32 to 47, comprising:
engaging the substrate with said planarizing medium
moving at least one of the substrate and the medium with respect to the other to translate the substrate across a planarizing surface of the medium;
supporting the substrate with the first raised features of the micro-features having the greatest heights; and
entrapping small volumes of solution between the first raised features and under the substrate as the substrate translates across the planarizing surface by restricting the solution with the second raised features.

49. The method of claim 48 wherein entrapping small volumes of the solution step comprises:
configuring the selected pattern of micro-features on the film to inhibit fluid flow of the solution under the substrate as the substrate translates across the planarizing surface; and
depositing the solution onto the film.

50. The method of claim 49 wherein the planarizing medium comprises a first portion and a second portion, and wherein the method further comprises:
engaging a first substrate with the first portion;
moving at least one of the first substrate and the first portion with respect to the other to translate the first substrate across a planarizing surface of the first portion;
replacing the first portion with the second portion after planarizing the first substrate;
engaging a second substrate with the second portion;
moving at least one of the second substrate and the second portion with respect to the other to translate the second substrate across a planarizing surface of the second portion.

51. The method of claim 50 wherein:
the first and second portions are formed together in a continuous web; and
replacing the first portion with the second portion comprises advancing the web to remove the first portion from a base of a planarizing machine and to position the second portion on the base.

52. The method of claim 50 wherein:
the first and second portions are separate sheets; and
replacing the first portion with the second portion comprises unclamping the first portion from a base of a planarizing machine, removing the first portion from the base, positioning the second portion on the base, and clamping the second portion on the base.

53. The method of claim 49 wherein:
the film is composed of a substantially incompressible polymer and the micro-features comprise a plurality of nodules formed from the film, the nodules having a plurality of different shapes and heights; and
the method further comprises preparing the medium for planarization prior to engaging the substrate with the medium by flattening a portion of the nodules at a maximum height across the planarizing surface.

54. The method of claim 53 wherein flattening a portion of the nodules comprises planarizing a sacrifice substrate on medium.

55. A method of planarizing a microelectronic substrate making use of the medium defined in any of claims 1 to 18 and 32 to 47, compising:
depositing a planarizing solution onto said planarizing medium;
engaging the substrate with the planarizing surface; and
moving at least one of the substrate and the medium with respect to the other to translate the substrate across a planarizing surface of the medium.

56. The method of claim 55 wherein the planarizing medium comprises a first portion and a second portion, the selected pattern being duplicated on the first and second portions, and wherein the method further comprises:
engaging a first substrate with the first portion;
moving at least one of the first substrate and the first portion with respect to the other to translate the first substrate across a planarizing surface of the first portion;
replacing the first portion with the second portion after planarizing the first substrate;
engaging a second substrate with the second portion;
moving at least one of the second substrate and the second portion with respect to the other to translate the second substrate across a planarizing surface of the second portion.

57. The method of claim 56 wherein:
the first and second portions are formed together in a continuous web; and
replacing the first portion with the second portion comprises advancing the web to remove the first portion from a base of a planarizing machine and to position the second portion on the base.

58. The method of claim 56 wherein:
the first and second portions are separate sheets; and
replacing the first portion with the second portion comprises unclamping the first portion from a base of a planarizing machine, removing the first portion from the base, positioning the second portion on the base, and clamping the second portion on the base.

59. The method of claim 56 wherein:
the film is composed of a substantially incompressible polymer and the micro-features comprise a plurality of nodules formed from the film, the nodules having a plurality of different shapes and heights; and
the method further comprises preparing the medium for planarization prior to engaging the substrate with the medium by flattening a portion of the nodules at a maximum height across the planarizing surface.

60. The method of claim 59, wherein flattening a portion of the nodules comprises planarizing a sacrifice substrate on medium.

61. A method of manufacturing microelectronic substrate polishing pads, comprising:
forming a defined pattern of non-abrasive micro-features on a planarizing surface of a first portion of a film impervious to a planarizing solution; and
duplicating the defined pattern of micro-features on a planarizing surface of a second portion of the film.

62. The method of claim 61 wherein:
the film comprises a polymer; and
forming the defined pattern of micro-features on the first portion of film comprises providing a die having a plurality of recesses arranged in the defined pattern to form a plurality of first and second raised features, and embossing the first portion of film with the die to form the defined pattern of first and second raised features on the surface of the film.

63. The method of claim 62 wherein duplicating the defined pattern of micro-features on the second portion of film comprises embossing the second portion of film with the die to duplicate the defined pattern of first and second raised features on the surface of the film.

64. The method of claim 61, wherein:
the film comprises a polymer; and
forming the defined pattern of micro-features on the first portion of film comprises attaching a portion of fine mesh of woven strands to the first portion of film.

65. The method of claim 64, wherein duplicating the defined pattern of micro-features on the second portion of film comprises attaching another portion of the fine mesh of woven strands to the second portion of film.

66. The method of claim 64, wherein
the film comprises a polymer; and
forming the defined pattern of micro-features on the first portion of film comprises etching the film through a master pattern to from a plurality of first and second raised features across the surface of the film.

67. The method of claim 66, wherein etching the film comprises:
forming a protective layer on the film having openings corresponding to depressions between the first and second raised features; and
etching the film through the openings.

68. The method of claim 66, wherein duplicating the defined pattern of micro-features on the second portion of film comprises duplicating the master pattern on the second portion of film and etching the film through the duplicated master pattern to from a plurality of first and second raised features across the surface of the film.

## Patentansprüche

1. Planarisiermedium (140, 240) zum Planarisieren mikroelektronischer Substrate, umfassend:
einen Planarisierfilm (142, 242), mehrere Mikromerkmale (146, 246), die in einem ausgewählten, duplizierten Muster auf dem Film ausgebildet sind, wobei das ausgebildete Muster eine Mehrzahl von ersten erhabenen Merkmalen (147, 247), die Abstützpunkte definieren, und unter denen mindestens ein Hohlraum liegt, und eine Mehrzahl zweiter erhabener Merkmale (249) zwischen und unterhalb der Abstützpunkte aufweist.

2. Medium nach Anspruch 1, bei dem der Film sich aus einem im wesentlichen nicht kompressiblen Polymer zusammensetzt und die ersten und die zweiten erhabenen Merkmale aus dem Film ausgebildet sind.

3. Medium nach Anspruch 2, bei dem das Polymer Polyester aufweist.

4. Medium nach Anspruch 2, bei dem das Co-Polymer Polycarbonat aufweist.

5. Medium nach Anspruch 2, bei dem das Polymer Polyurethan aufweist.

6. Medium nach Anspruch 2, bei dem das Polymer Nylon aufweist.

7. Medium nach Anspruch 2, bei dem die ersten und zweiten erhabenen Merkmale Knötchen mit mehreren Formen und Höhen aufweisen, wobei die Knötchen auf dem Film ein Muster bilden, so dass mehrere Vertiefungen zwischen den Knötchen vorhanden sind und zumindest ein Abschnitt der Knötchen je einen der Abstützpunkte bildet.

8. Medium nach Anspruch 7, bei dem die ersten erhabenen Merkmale flache Oberseiten aufweisen, die mit einer konstanten maximalen Höhe über der Planarisierfläche des Films abschließen.

9. Medium nach Anspruch 7, bei dem die Knötchen dem Film aufgeprägt sind.

10. Medium nach Anspruch 9, bei dem das ausgewählte Muster eine im wesentlichen zufällige Konfiguration von Knötchen über eine Arbeitszone der Planarisierfläche aufweist.

11. Medium nach Anspruch 10, bei dem das Polymer Polyester aufweist.

12. Medium nach Anspruch 10, bei dem das Co-Polymer Polycarbonat aufweist.

13. Medium nach Anspruch 1, bei dem
der Film einen Polymerkörper mit einer Oberseite aufweist; und
die Mikromerkmale ein feines Netzt auf der Oberseite des Films mit gewebten Strängen aufweist, wobei die ersten erhabenen Merkmale hochgelegene Punkte entlang den Strängen sind und die zweiten erhabenen Merkmale Seitenabschnitte der Stränge sind.

14. Medium nach Anspruch 13, bei dem
das Polymer Polyester aufweist; und
das feine Netz kleine Nylonfasern enthält, die zu einem Maschennetz mit 0,5 % bis 5 % Öffnungen verwoben sind.

15. Medium nach Anspruch 14, bei dem die Nylonfaser Fasern in einer Grösse von 2,0 µm bis 5,0 µm aufweisen.

16. Medium nach Anspruch 1, bei dem der Film eine flexible Materialbahn aufweist, die um eine Vorratsrolle und eine Aufnahmerolle gewickelt ist, wobei das Muster aus Mikromerkmalen über die Bahn hinweg dupliziert ist.

17. Medium nach Anspruch 16, bei dem ein erster Abschnitt der Materialbahn auf einer Arbeitsstation einer Planarisiermaschine zum Planarisieren eines ersten Substrats gehalten wird, und die Materialbahn anschließend zu einem zweiten Abschnitt der Materialbahn auf der Arbeitsstation vorgerückt wird, um eine zweites Substrat zu Planarisieren.

18. Medium nach Anspruch 1, bei dem der Planarisierfilm ein an eine Arbeitsstation einer Planarisiermaschine lösbar befestigtes Separierblatt aufweist.

19. Planarisiermaschine zum Planarisieren eines mikroelektronischen Substrats, umfassend:
das Planarisiermedium gemäß einem der Ansprüche 1 bis 18;
eine Trägerbasis; und
den separaten, nicht-abtragenden und nicht-komprimierbaren Planarisierfilm, der auf der Basis angeordnet ist, wobei die ersten erhabenen Merkmale erste Spitzen in einer ersten Höhe aufweisen, welche die Abstützpunkte definieren, um das Substrat zu kontaktieren, und die zweiten erhabenen Merkmale zweite Spitzen in einer Höhe aufweisen, die geringer ist als die erste Höhe.

20. Planarisiermaschine nach Anspruch 19, bei der der Film eine flexible Materialbahn aufweist, die um eine Vorratsrolle und eine Aufnahmerolle gewickelt ist, wobei ein Abschnitt der Materialbahn, der sich zwischen Vorratsund Aufnahmerolle erstreckt, über der Basis gehalten wird.

21. Planarisiermaschine nach Anspruch 20, bei der die Materialbahn während der Planarisierung dadurch stationär oberhalb der Basis gehalten wird, dass die Materialbahn zwischen Vorrats- und Aufnahmerolle unter Spannung gehalten wird.

22. Planarisiermaschine nach Anspruch 19, bei der der Film ein getrenntes, abnehmbar an der Basis befestigtes Blatt aufweist.

23. Planarisiermaschine nach Anspruch 22, bei der das Blatt mit Spannung an der Basis festgeklemmt ist.

24. Planarisiermaschine nach Anspruch 19, bei der die Basis eine nicht komprimierbare Platte aufweist.

25. Planarisiermaschine nach Anspruch 19, bei der der Film sich aus einem im wesentlichen nicht komprimierbaren Polymer zusammensetzt und die Mikromerkmale aus dem Film ausgebildet sind.

26. Planarisiermaschine nach Anspruch 19, bei der die Mikromerkmale Knötchen mit einer Mehrzahl von Formen und Höhen aufweisen, wobei die Knötchen auf dem Film als Muster ausgebildet sind, um mehrere Vertiefungen zwischen den Knötchen zu bilden, die die Lösung einfangen.

27. Planarisiermaschine nach Anspruch 26, bei der ein Teil der Knötchen mit flachen Oberseiten in einer konstanten maximalen Höhe über der Planarisierfläche des Films abschliessen.

28. Planarisiermaschine nach Anspruch 26, bei der die Knötchen dem Film eingeprägt sind.

29. Planarisiermaschine nach Anspruch 26, bei dem die Vertiefungen in den Film eingeätzt sind.

30. Planarisiermaschine nach Anspruch 26, bei dem das ausgewählte muster im wesentlichen eine Zufalls-Konfiguration von Knötchen entlang einer Arbeitszone der Planarisierfläche ist.

31. Planarisiermaschine nach Anspruch 19, bei der
der Film ein Polymer enthält; und
die Mikromerkmale ein feines Netz auf dem Film bilden.

32. Medium nach Anspruch 1, bei dem der Planarisierfilm ein einschichtiger Wegwerf-Planarisierfilm mit einer Dicke zwischen etwa 0,0005 und 0,050 Zoll und einer Planarisierfläche mit mehreren Mikromerkmalen, wobei die Mikromerkmale feine Vertiefungen in der Planarisierfläche mit Tiefen zwischen 0,5 und 100 µm definieren.

33. Planarisiermedium nach Anspruch 32, bei dem der Film eine flexible Materialbahn aufweist, ausgebildet zum Wickeln um eine Vorratsrolle und eine Aufnahmerolle derart, dass die Materialbahn über eine Planarisierstation einer Planarisiermaschine weitergerückt werden kann.

34. Medium nach Anspruch 33, bei dem die Materialbahn ein Polymermaterial aufweist.

35. Medium nach Anspruch 34, bei dem das Polymermaterial Polyester aufweist.

36. Medium nach Anspruch 34, bei dem das Polymermaterial Polycarbonat aufweist.

37. Medium nach Anspruch 34, bei dem die Polymerbahn eine Dicke zwischen etwa 0,0005 und etwa 0,003 Zoll aufweist.

38. Medium nach Anspruch 37, bei dem die Tiefen der Vertiefungen, die durch die Mikromerkmale gebildet werden, etwa zwischen 1 und 10 µm liegen.

39. Medium nach Anspruch 38, bei dem die Materialbahn mehrere Abschnitte aufweist, von denen jeder Abschnitt ein identisches Muster von Mikromerkmalen besitzt.

40. Medium nach Anspruch 32, bei der Film ein zur Anbringung an einer Planarisierstation einer Planarisiermaschine ausgebildetes Blatt aufweist.

41. Medium nach Anspruch 40, bei dem das Blatt ein Polymermaterial aufweist.

42. Medium nach Anspruch 41, bei dem das Polymermaterial Polyester aufweist.

43. Medium nach Anspruch 41, bei dem das Polymermaterial Polymcarbonat aufweist.

44. Medium nach Anspruch 41, bei dem das Co-Polymerblatt eine Dicke zwischen etwa 0,0005 und 0,003 Zoll aufweist.

45. Medium nach Anspruch 44, bei dem die Tiefen der durch die Mikromerkmale gebildeten Vertiefungen zwischen etwa 1 und 10 µm liegen.

46. Medium nach Anspruch 45, bei dem das Blatt eine Mehrzahl von Abschnitten besitzt, von denen jeder Abschnitt ein identisches Muster von Mikromerkmalen aufweist.

47. Medium nach Anspruch 32, bei dem die Tiefen der durch die Mikromerkmale gebildeten Vertiefungen etwa zwischen 0,5 µm und 10 µm liegen.

48. Verfahren zum Planarisieren eines mikroelektronischen Substrats unter Verwendung des Planarisiermediums nach einem der Ansprüche 1 bis 18 und 32 bis 47, umfassend:
Bewegen des Substrats und/oder des Mediums in Bezug aufeinander, um das Substrat gegenüber einer Planarisierfläche des Mediums zu verlagern;
Abstützen des Substrats mit den ersten erhabenen Merkmalen der Mikromerkmale mit den größten Höhen; und
Einfangen kleiner Volumina einer Lösung zwischen den ersten erhabenen Merkmalen und unterhalb des Substrats, während sich das Substrat translatorisch über die Planarisierfläche bewegt, indem die Lösung mit den zweiten erhabenen Merkmalen eingeengt wird.

49. Verfahren nach Anspruch 48, bei dem das Einfangen kleiner Volumina der Lösung beinhaltet:
Konfigurieren des ausgewählten Musters von Mikromerkmalen auf dem Film derart, das ein Fluidstrom der Lösung unter das Substrat verhindert wird, während sich das Substrat translatorisch über der Planarisierfläche bewegt; und
Aufbringen der Lösung auf den Film.

50. Verfahren nach Anspruch 49, bei dem das Planarisiermedium einen ersten und einen zweiten Abschnitt aufweist, und das Verfahren weiterhin beinhaltet:
In-Eingriff-Bringen eines ersten Substrats mit dem ersten Abschnitt;
Bewegen des ersten Substrats und/oder des ersten Abschnitts gegeneinander, um das erste Subsrat translatorisch über die Planarisierfläche des ersten Abschnitts zu bewegen;
Ersetzen des ersten Abschnitts durch den zweiten Abschnitt, nachdem das erste Substrat planarisiert ist;
In-Eingriff-Bringen eines zweiten Substrats mit dem zweiten Abschnitt;
Bewegen des zweiten Substrats und/oder des zweiten Abschnitts gegeneinander, um das zweite Substrat translatorisch über eine Planarisierfläche des zweiten Abschnitts zu bewegen.

51. Verfahren nach Anspruch 50, bei dem:
der erste und der zweite Abschnitt gemeinsam in einer durchgehenden Materialbahn ausgebildet sind; und
Ersetzen des ersten Abschnitts durch den zweiten Abschnitt, indem die Materialbahn vorgerückt wird, um den ersten Abschnitt von einer Basis einer Planarisiermaschine zu entfernen und den zweiten Abschnitt auf der Basis zu positionieren.

52. Verfahren nach Anspruch 50, bei dem
der erste und der zweite Abschnitt getrennte Blätter sind;
das Austauschen des ersten Abschnitts durch den zweiten Abschnitt das Losklammern des ersten Abschnitts von einer Basis einer Planarisiermaschine, das Entfernen des ersten Abschnitts von der Basis, das Positionieren des zweiten Abschnitts auf der Basis und das Festklemmen des zweiten Abschnitts an der Basis beinhaltet.

53. Verfahren nach Anspruch 49, bei dem
der Film sich aus einem im wesentlichen nicht komprimierbaren Polymer zusammensetzt und die Mikromerkmale eine Mehrzahl von Knötchen aufweisen, die aus dem Film ausgebildet sind, und die eine Mehrzahl unterschiedlicher Formen und Höhen aufweisen; und
das Verfahren weiterhin das Vorbereiten des Mediums zum Planarisieren beinhaltet, bevor das Substrat mit dem Medium in Eingriff gebracht wird, indem ein Abschnitt der Knötchen maximaler Höhe auf der Planarisierfläche flach ausgebreitet wird.

54. Verfahren nach Anspruch 53, bei dem das flache Ausbreiten eines Abschnitts der Knötchen ein Planarisieren eines Opfersubstrats an dem Medium beinhaltet.

55. Verfahren zum Planarisieren eines mikroelektronischen Substrats unter Verwendung des Mediums nach einem der Ansprüche 1 bis 18 und 32 bis 47, umfassend:
das Substrat wird mit der Planarisierfläche in Eingriff gebracht; und
das Substrat und/oder das Medium wird gegenüber dem anderen Teil bewegt, um das Substrat translatorisch über eine Planarisierfläche des Mediums zu bewegen.

56. Verfahren nach Anspruch 55, bei dem das Planarisiermedium aufweist:
einen ersten und einen zweiten Abschnitt, wobei das ausgewählte Muster auf dem ersten und dem zweiten Abschnitt dupliziert ist, wobei das Verfahren ausserdem beinhaltet:
In-Eingriff-Bringen eines ersten Substrats mit dem ersten Abschnitt; Bewegen des ersten Substrats und/oder des ersten Abschnitts gegeneinander, um das erste Subsrat translatorisch über die Planarisierfläche des ersten Abschnitts zu bewegen;
Ersetzen des ersten Abschnitts durch den zweiten Abschnitt, nachdem das erste Substrat planarisiert ist;
In-Eingriff-Bringen eines zweiten Substrats mit dem zweiten Abschnitt; Bewegen des zweiten Substrats und/oder des zweiten Abschnitts gegeneinander, um das zweite Substrat translatorisch über eine Planarisierfläche des zweiten Abschnitts zu bewegen.

57. Verfahren nach Anspruch 56, bei dem:
der erste und der zweite Abschnitt gemeinsam in einer durchgehenden Materialbahn ausgebildet sind; und
Ersetzen des ersten Abschnitts durch den zweiten Abschnitt, indem die Materialbahn vorgerückt wird, um den ersten Abschnitt von einer Basis einer Planarisiermaschine zu entfernen und den zweiten Abschnitt auf der Basis zu positionieren.

58. Verfahren nach Anspruch 56, bei dem:
der erste und der zweite Abschnitt getrennte Blätter sind;
das Austauschen des ersten Abschnitts durch den zweiten Abschnitt das Losklammern des ersten Abschnitts von einer Basis einer Planarisiermaschine, das Entfernen des ersten Abschnitts von der Basis, das Positionieren des zweiten Abschnitts auf der Basis und das Festklemmen des zweiten Abschnitts an der Basis beinhaltet.

59. Verfahren nach Anspruch 56, bei dem:
der Film sich aus einem im wesentlichen nicht komprimierbaren Polymer zusammensetzt und die Mikromerkmale eine Mehrzahl von Knötchen aufweisen, die aus dem Film ausgebildet sind, und die eine Mehrzahl unterschiedlicher Formen und Höhen aufweisen; und
das Verfahren weiterhin das Vorbereiten des Mediums zum Planarisieren beinhaltet, bevor das Substrat mit dem Medium in Eingriff gebracht wird, indem ein Abschnitt der Knötchen maximaler Höhe-auf der Planarisierfläche flach ausgebreitet wird.

60. Verfahren nach Anspruch 59, bei dem das flache Ausbreiten eines Abschnitts der Knötchen ein Planarisieren eines Opfersubstrats an dem Medium beinhaltet.

61. Verfahren zum Herstellen von Polierkissen zum Polieren eines mikroelektronischen Substrats, umfassend:
Ausbilden eines definierten Musters von nicht-abreibenden Mikromerkmalen auf einer Planarisierfläche eines ersten Abschnitts eines Films, der für eine Planarisierlösung undurchdringlich ist; und
Duplizieren des definierten Musters von Mikromerkmalen auf einer Planarisierfläche eines zweiten Abschnitts des Films.

62. Verfahren nach Anspruch 61, bei dem
der Film ein Polymer aufweist; und
Ausbilden des definierten Musters aus Mikromerkmalen auf dem ersten Abschnitt des Films, umfassend das Bereitstellen einer Form mit mehreren Vertiefungen, die in dem definierten Muster angeordnet sind, um mehrere erste und zweite erhabene Merkmale zu bilden, und Prägen des ersten Abschnitts des Films mit der Form, um das definierte Muster mit den ersten und zweiten erhabenen Merkmalen auf der Oberfläche des Films zu formen.

63. Verfahren nach Anspruch 62, bei dem das Duplizieren des definierten Musters von Mikromerkmalen in dem zweiten Abschnitt des Films das Prägen des zweiten Filmabschnitts mit der Form zum Duplizieren des definierten Musters der ersten und der zweiten erhabenen Merkmale auf der Oberfläche des Films beinhaltet.

64. Verfahren nach Anspruch 61, bei dem der Film ein Polymer aufweist;
das definierte Muster von Mikromerkmalen auf dem ersten Abschnitt des Films beinhaltet, einen Abschnitt eines feinen Netzes auf verwobenen Strängen an dem ersten Filmabschnitt zu befestigen.

65. Verfahren nach Anspruch 64, bei dem das Duplizieren des definierten Musters von Mikromerkmalen an dem zweiten Abschnitt des Films das Befestigen eines weiteren Abschnitts des feinen Netzes verwobener Stränge an dem zweiten Filmabschnitt beinhaltet.

66. Verfahren nach Anspruch 64, bei dem
der Film ein Polymer aufweist; und
das Ausbilden des definierten Musters von Mikromerkmalen in dem ersten Filmabschnitt beinhaltet: Ätzen des Films durch ein Master-Muster, um mehrere erste und zweite erhabene Merkmale auf der Filmoberfläche zu bilden.

67. Verfahren nach Anspruch 66, bei dem das Ätzen des Films beinhaltet:
Ausbilden einer Schutzschicht auf dem Film mit Öffnungen entsprechend den Vertiefungen zwischen den ersten und zweiten erhabenen Merkmalen; und
Ätzen des Films durch die Öffnungen hindurch.

68. Verfahren nach Anspruch 66, bei dem das Duplizieren des definierten Musters von Mikromerkmalen in dem zweiten Filmabschnitt beinhaltet:
Duplizieren des Master-Musters auf dem zweiten Abschnitt des Films und
Ätzen des Films durch das duplizierte Master-Muster, um mehrere erste und zweite erhabene Merkmale auf der Filmoberfläche zu bilden.

## Revendications

1. Milieu (140, 240) d'aplanissement destiné à aplanir des substrats microélectroniques, comprenant :
- un film (142, 242) d'aplanissement imperméable à une solution ; et
- une pluralité de micro-reliefs (146, 246) configurés en un motif choisi, reproduit sur le film, le motif choisi comportant une pluralité de premiers reliefs élevés (147, 247) définissant des points de support, au moins une cavité en dessous des points de support et une pluralité de seconds reliefs élevés (249) entre et au-dessous des points de support.

2. Milieu d'aplanissement selon la revendication 1, dans lequel le film est composé d'un polymère essentiellement incompressible et les premier et second reliefs élevés sont formés à partir du film.

3. Milieu d'aplanissement selon la revendication 2, dans lequel le polymère comprend un polyester.

4. Milieu d'aplanissement selon la revendication 2, dans lequel le copolymère comprend un polycarbonate.

5. Milieu d'aplanissement selon la revendication 2, dans lequel le polymère comprend du polyuréthane.

6. Milieu d'aplanissement selon la revendication 2, dans lequel le polymère comprend du nylon.

7. Milieu d'aplanissement selon la revendication 2, dans lequel les premier et second reliefs élevés comprennent des nodules présentant une pluralité de formes et de hauteurs, les nodules étant formés en motifs sur le film pour former une pluralité de creux entre les nodules et de sorte qu'au moins une partie des nodules définisse les points de support.

8. Milieu d'aplanissement selon la revendication 7, dans lequel les premiers reliefs élevés ont des sommets plats se terminant à une hauteur maximale constante sur la surface d'aplanissement du film.

9. Milieu d'aplanissement selon la revendication 7, dans lequel les nodules sont bosselés sur le film.

10. Milieu d'aplanissement selon la revendication 9, dans lequel le motif choisi est une configuration essentiellement aléatoire de nodules sur une région de travail de la surface d'aplanissement.

11. Milieu d'aplanissement selon la revendication 10, dans lequel le polymère comprend un polyester.

12. Milieu d'aplanissement selon la revendication 10, dans lequel le copolymère comprend du polycarbonate.

13. Milieu d'aplanissement selon la revendication 1, dans lequel:
le film comprend un corps de polymère avec une surface supérieure ; et
les micro-reliefs comprennent un fin treillis sur la surface supérieure du film, comportant des torons tissés, les premiers reliefs élevés étant des points élevés le long des torons et les seconds reliefs élevés étant des parties latérales des torons.

14. Milieu d'aplanissement selon la revendication 13, dans lequel :
le polymère comprend du polyester ; et
le fin treillis comprend de petites fibres de nylon tissées en un treillis ayant 0,5 % à 5 % d'ouvertures.

15. Milieu d'aplanissement selon la revendication 14, dans lequel la fibre de nylon comprend des fibres de 2,0 µm à 5,0 µm.

16. Milieu d'aplanissement selon la revendication 1, dans lequel le film comprend une bande flexible enroulée autour d'un rouleau d'alimentation et d'un rouleau récepteur et dans lequel le motif des micro-reliefs est reproduit sur la bande.

17. Milieu d'aplanissement selon la revendication 16, dans lequel une première partie de la bande est maintenue au niveau d'un poste de travail d'une machine d'aplanissement pour aplanir un premier substrat, et la bande est ultérieurement avancée pour positionner une seconde partie de la bande au niveau du poste de travail pour aplanir un second substrat.

18. Milieu d'aplanissement selon la revendication 1, dans lequel le film d'aplanissement comprend une feuille séparée attachée de manière amovible à un poste de travail d'une machine d'aplanissement.

19. Machine d'aplanissement destinée à aplanir un substrat microélectronique, comprenant :
le milieu d'aplanissement tel que défini dans l'une quelconque des revendications 1 à 18 ;
une base de support ;
ledit film d'aplanissement non abrasif incompressible, séparé étant placé sur la base de support, lesdits premiers reliefs élevés ayant des premiers pics à une première hauteur définissant des points de support pour entrer en contact avec le substrat, et les seconds reliefs élevés ayant des seconds pics à des hauteurs plus faibles que la première hauteur.

20. Machine d'aplanissement selon la revendication 19, dans laquelle le film comprend une bande flexible enroulée autour d'un rouleau d'alimentation et d'un rouleau récepteur, et dans laquelle une partie de la bande s'étendant entre le rouleau d'alimentation et le rouleau récepteur est maintenue sur la base de support.

21. Machine d'aplanissement selon la revendication 20, dans laquelle la bande est maintenue stationnaire sur la base de support pendant l'aplanissement par mise en tension de la bande entre le rouleau d'alimentation et le rouleau récepteur.

22. Machine d'aplanissement selon la revendication 19, dans laquelle le film comprend une feuille séparée attachée de manière amovible à la base de support.

23. Machine d'aplanissement selon la revendication 22, dans laquelle la feuille est serrée sous tension contre la base.

24. Machine d'aplanissement selon la revendication 19, dans laquelle la base comprend une plaque incompressible.

25. Machine d'aplanissement selon la revendication 19, dans laquelle le film est composé d'un polymère essentiellement incompressible et les micro-reliefs sont formés à partir du film.

26. Machine d'aplanissement selon la revendication 19, dans laquelle les micro-reliefs comprennent des nodules ayant une pluralité de formes et de hauteurs, les nodules étant formés en motifs sur le film pour former une pluralité de creux entre les nodules qui piègent la solution.

27. Machine d'aplanissement selon la revendication 26, dans laquelle une partie des nodules ont des sommets plats se terminant à une hauteur maximale constante sur la surface d'aplanissement du film.

28. Machine d'aplanissement selon la revendication 26, dans laquelle les nodules sont bosselés sur le film.

29. Machine d'aplanissement selon la revendication 26, dans laquelle les creux sont gravés chimiquement dans le film.

30. Machine d'aplanissement selon la revendication 26, dans laquelle le motif choisi est une configuration essentiellement aléatoire de nodules sur une région de travail de la surface d'aplanissement.

31. Machine d'aplanissement selon la revendication 19, dans laquelle :
le film comprend un polymère ; et
les micro-reliefs comprennent un fin treillis sur le film.

32. Milieu d'aplanissement selon la revendication 1, dans lequel ledit film d'aplanissement est un film d'aplanissement monocouche à usage unique ayant une épaisseur comprise entre approximativement 0,0005 et 0,050 pouce et une surface d'aplanissement comportant une pluralité de micro-reliefs, la pluralité de micro-reliefs définissant des petits creux dans la surface d'aplanissement ayant des profondeurs comprise entre 0,5 et 100 µm.

33. Milieu d'aplanissement selon la revendication 32, dans lequel le film comprend une bande flexible conçue pour être enroulée autour d'un rouleau d'alimentation et d'un rouleau récepteur, de sorte que la bande peut être indexée dans un poste d'aplanissement d'une machine d'aplanissement.

34. Milieu d'aplanissement selon la revendication 33, dans lequel la bande comprend un matériau polymère.

35. Milieu d'aplanissement selon la revendication 34, dans lequel le matériau polymère comprend du polyester.

36. Milieu d'aplanissement selon la revendication 34, dans lequel le matériau polymère comprend du polycarbonate.

37. Milieu d'aplanissement selon la revendication 34, dans lequel la bande polymère présente une épaisseur comprise approximativement entre 0,0005 et 0,003 pouce.

38. Milieu d'aplanissement selon la revendication 37, dans lequel les profondeurs des creux formés par les micro-reliefs sont comprise approximativement entre 1 et 10 µm.

39. Milieu d'aplanissement selon la revendication 38, dans lequel la bande présente une pluralité de sections et chaque section a un motif identique de micro-reliefs.

40. Milieu d'aplanissement selon la revendication 32, dans lequel le film comprend une feuille conçue pour être attachée à un poste d'aplanissement d'une machine d'aplanissement.

41. Milieu d'aplanissement selon la revendication 40, dans lequel la feuille comprend un matériau polymère.

42. Milieu d'aplanissement selon la revendication 41, dans lequel le matériau polymère comprend du polyester.

43. Milieu d'aplanissement selon la revendication 41, dans lequel le matériau polymère comprend du polycarbonate.

44. Milieu d'aplanissement selon la revendication 41, dans lequel la feuille copolymère a une épaisseur comprise approximativement entre 0,0005 et 0,003 pouce.

45. Milieu d'aplanissement selon la revendication 44, dans lequel les profondeurs des creux formés par les micro-reliefs sont comprises approximativement entre 1 et 10 µm.

46. Milieu d'aplanissement selon la revendication 45, dans lequel la feuille a une pluralité de sections et chaque section a un motif identique de micro-reliefs.

47. Milieu d'aplanissement selon la revendication 32, dans lequel les profondeurs des creux formés par les micro-reliefs sont comprises approximativement entre 0,5 µm et 10 µm.

48. Procédé d'aplanissement d'un substrat microélectronique faisant usage du milieu d'aplanissement défini dans l'une quelconque des revendications 1 à 18 et 32 à 47 consistant à :
mettre le substrat en contact avec ledit milieu d'aplanissement;
déplacer au moins l'un du substrat et du milieu par rapport à l'autre pour translater le substrat en travers d'une surface d'aplanissement du milieu ;
faire supporter le substrat par les premiers reliefs élevés des micro-reliefs ayant les hauteurs les plus grandes ; et
piéger de petits volumes de solution entre les premiers reliefs élevés et sous le substrat pendant que le substrat se translate en travers de la surface d'aplanissement en limitant la solution avec les seconds reliefs élevés.

49. Procédé selon la revendication 48, dans lequel l'étape consistant à piéger de petits volumes de solution consiste à :
configurer le motif choisi de micro-reliefs sur le film pour empêcher l'écoulement du fluide de la solution sous le substrat à mesure que le substrat se translate en travers de la surface d'aplanissement ; et
déposer la solution sur le film.

50. Procédé selon la revendication 49, dans lequel le milieu d'aplanissement comprend une première partie et une seconde partie, et dans lequel le procédé consiste, en outre, à :
mettre un premier substrat en contact avec la première partie ;
déplacer au moins l'un du premier substrat et de la première partie par rapport à l'autre pour translater le premier substrat en travers d'une surface d'aplanissement de la première partie ;
remplacer la première partie par la seconde partie après aplanissement du premier substrat ;
mettre un second substrat en contact avec la seconde partie ;
déplacer au moins l'un du second substrat et de la seconde partie par rapport à l'autre pour translater le second substrat en travers d'une surface d'aplanissement de la seconde partie.

51. Procédé selon la revendication 50, dans lequel :
les première et seconde parties sont formées ensemble en une bande continue ; et
le remplacement de la première partie par la seconde consiste à avancer la bande pour enlever la première partie d'une base d'une machine d'aplanissement et pour positionner la seconde partie sur la base.

52. Procédé selon la revendication 50, dans lequel :
les première et seconde parties sont des feuilles séparées ; et
le remplacement de la première partie par la seconde partie consiste à desserrer la première partie par rapport à une base d'une machine d'aplanissement, enlever la première partie de la base, positionner la seconde partie sur la base et serrer la seconde partie sur la base.

53. Procédé selon la revendication 49, dans lequel :
le film est composé d'un polymère essentiellement incompressible et les micro-reliefs comprennent une pluralité de nodules formés à partir du film, les nodules présentant une pluralité de formes et de hauteurs différentes ; et
le procédé consiste, en outre, à préparer le milieu d'aplanissement avant de mettre le substrat en contact avec le milieu, en aplatissant une partie des nodules à une hauteur maximale sur la surface d'aplanissement.

54. Procédé selon la revendication 53, dans lequel l'aplatissement d'une partie des nodules comprend l'aplanissement d'un substrat sacrificiel sur le milieu.

55. Procédé d'aplanissement d'un substrat microélectronique faisant usage du milieu défini dans l'une quelconque des revendications 1 à 18 et 32 à 47, consistant à :
déposer une solution d'aplanissement sur ledit milieu d'aplanissement ;
mettre le substrat en contact avec une surface d'aplanissement ; et
déplacer au moins l'un du substrat et du milieu par rapport à l'autre pour translater le substrat en travers d'une surface d'aplanissement du milieu.

56. Procédé selon la revendication 55, dans lequel le milieu d'aplanissement comprend une première partie et une seconde partie, le motif choisi étant reproduit sur les première et seconde parties, et dans lequel le procédé consiste, en outre, à :
mettre un premier substrat en contact avec la première partie ;
déplacer au moins l'un du premier substrat et de la première partie par rapport à l'autre pour translater le premier substrat en travers d'une surface d'aplanissement de la première partie ;
remplacer la première partie par la seconde partie après aplanissement du premier substrat ;
mettre un second substrat en contact avec la seconde partie ;
déplacer au moins l'un du second substrat et de la seconde partie par rapport à l'autre pour translater le second substrat en travers d'une surface d'aplanissement de la seconde partie.

57. Procédé selon la revendication 56, dans lequel :
les première et seconde parties sont formées ensemble en une bande continue ; et
le remplacement de la première partie par la seconde partie consiste à avancer la bande pour enlever la première partie d'une base d'une machine d'aplanissement et pour positionner la seconde partie sur la base.

58. Procédé selon la revendication 56, dans lequel :
les première et seconde parties sont des feuilles séparées ; et
le remplacement de la première partie par la seconde partie consiste à desserrer la première partie par rapport à une base d'une machine d'aplanissement, enlever la première partie de la base, positionner la seconde partie sur la base et serrer la seconde partie sur la base.

59. Procédé selon la revendication 56, dans lequel :
le film est composé d'un polymère essentiellement incompressible et les micro-reliefs comprennent une pluralité de nodules formés à partir du film, les nodules ayant une pluralité de formes et de hauteurs différentes ; et
le procédé consiste, en outre, à préparer le milieu d'aplanissement avant de mettre le substrat en contact avec le milieu, en aplatissant une partie des nodules à une hauteur maximale sur la surface d'aplanissement.

60. Procédé selon la revendication 59, dans lequel l'aplatissement d'une partie des nodules comprend l'aplanissement d'un substrat sacrificiel sur le milieu.

61. Procédé de fabrication de tampons de polissage de substrat microélectronique, consistant à :
former un motif défini de micro-reliefs non abrasifs sur une surface d'aplanissement d'une première partie d'un film imperméable à une solution d'aplanissement ; et
reproduire le motif défini de micro-reliefs sur une surface d'aplanissement d'une seconde partie du film.

62. Procédé selon la revendication 61, dans lequel :
le film comprend un polymère ; et
la formation du motif défini de micro-reliefs sur une première partie du film consiste à fournir une matrice comportant une pluralité de creux agencés selon le motif défini pour former une pluralité des premier et second reliefs élevés, et à bosseler la première partie du film avec la matrice pour former le motif défini des premier et second reliefs élevés sur la surface du film.

63. Procédé selon la revendication 62, dans lequel la reproduction du motif défini de micro-reliefs sur la seconde partie du film consiste à bosseler la seconde partie du film avec la matrice pour reproduire le motif défini des premier et second reliefs élevés sur la surface du film.

64. Procédé selon la revendication 61, dans lequel :
le film comprend un polymère ; et
la formation du motif défini de micro-reliefs sur la première partie du film consiste à attacher une partie d'un fin treillis de torons tissés à la première partie du film.

65. Procédé selon la revendication 64, dans lequel la reproduction du motif défini de micro-reliefs sur la seconde partie du film consiste à attacher une autre partie de fin treillis de torons tissés à la seconde partie du film.

66. Procédé selon la revendication 64, dans lequel :
le film comprend un polymère ; et
la formation du motif défini de micro-reliefs sur la première partie du film consiste à graver chimiquement le film à travers un modèle original pour former une pluralité de premier et second reliefs élevés sur la surface du film.

67. Procédé selon la revendication 66, dans lequel la gravure chimique du film consiste à :
former une couche protectrice sur le film présentant des ouvertures correspondant aux creux entre les premier et second reliefs élevés ; et
attaquer chimiquement le film à travers les ouvertures.

68. Procédé selon la revendication 66, dans lequel la reproduction du motif défini de micro-reliefs sur la seconde partie du film consiste à reproduire le modèle original sur la seconde partie du film et graver chimiquement le film à travers le modèle original reproduit pour former une pluralité de premier et second reliefs élevés sur la surface du film.
